# EUROPEAN PATENT APPLICATION

(11) **EP 4 261 894 A1**
(43) Date of publication of application: **18.10.2023**
(21) Application number: 22168316.2
(22) Date of filing: 14.04.2022
(51) Int. Cl.: H01L 29/78, H01L 21/336, H01L 29/40

(54) **TRENCH-GATE SEMICONDUCTOR DEVICE AND METHOD FOR MANUFACTURING THE SAME**

(71) Applicant: Nexperia B.V., 6534 AB Nijmegen (NL)
(72) Inventor: Siddiqui, Imran, Manchester SK7 5BJ (GB); Peake, Steven, Manchester SK7 5BJ (GB)
(74) Representative: Pjanovic, Ilija

(57) **Abstract**

The present disclosure relates to a trench-gate semiconductor device and a manufacturing method therefor. The device comprises one or more unit cells, and each unit cell comprises a trench a first oxide layer arranged on an upper portion of a side wall of the trench, said first oxide layer forming a gate oxide of the unit cell, and a second oxide layer arranged on a lower portion of the side wall and on a bottom of the trench. Furthermore, each unit cell comprises a gate arranged inside the trench, separated from the upper portion of the side wall by the first oxide layer, said first polysilicon region forming a gate of the unit cell, a second polysilicon region arranged inside the trench, separated from the lower portion of the side wall and from the bottom of the trench by the second oxide layer, said second polysilicon region forming a buried source of the unit cell, and a third oxide layer arranged in between the first polysilicon region and the second polysilicon region. Furthermore, each unit cell comprises a body region of a first charge type, wherein the body region is separated from the gate by the first oxide layer. A first distance from a top surface of the semiconductor region to a bottom surface of the body region is equal to or less than 3 micron, and a second distance from said top surface of the semiconductor region to a bottom surface of the first polysilicon region extends at least 0.3 micron beyond said bottom surface of the body region.

## Description

### FIELD

Aspects of the present disclosure relate to a trench-gate semiconductor device. Aspects of the present disclosure further relate to a method for manufacturing such a semiconductor device.

### BACKGROUND

Trench technology for semiconductor devices, such as trench metal-oxide-semiconductor field-effect transistors (MOSFETs), is widely used in various types of electronic devices. In known trench-MOSFETs, a gate electrode of the MOSFET is buried in a trench etched in a semiconductor region to form a vertical structure, which enhances the channel density of the device.

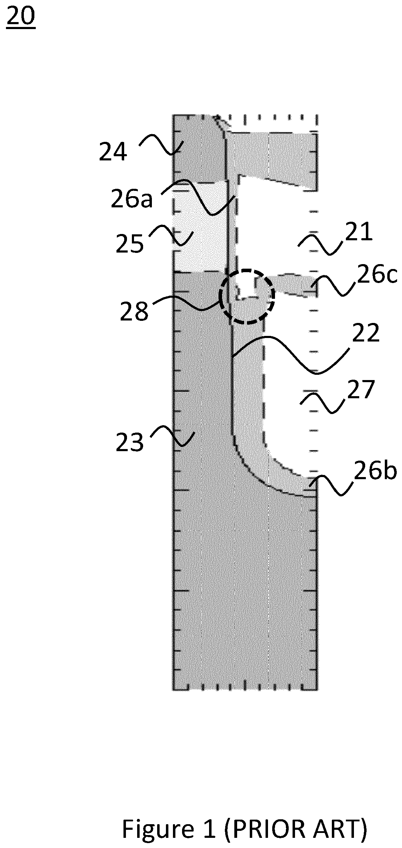

A cross-sectional view of a portion of a known trench-MOSFET structure 20 is shown in Figure 1. The known device comprises a poly silicon gate region 21 provided in a trench 22 arranged inside a silicon semiconductor region. As shown in figure 1, the semiconductor region comprises a substrate of a charge type and an epitaxial layer 23 arranged on the substrate and also being of the charge type. Inside epitaxial layer 23, a source region 24 and a body region 25 are formed. Source region 24 is of the same charge type as epitaxial layer 23, whereas body region 25 is of another charge type different from that of the substrate, epitaxial layer 23 and source region 24. Source region 24 and body region 25 are typically formed by means of ion implantation. For example, body region 25 is of a first charge type, corresponding to one of p-type and n-type doping, whereas the substrate, epitaxial layer 23 and source region 24 are of a second charge type, corresponding to another of p-type and n-type doping. Hereinafter, the non-implanted region of epitaxial layer 23 will be referred to as drift region 23. Furthermore, on the bottom of the substrate, a drain terminal of the trench-MOSFET is provided.

Trench-MOSFET structure 20 comprises a first oxide layer 26a that forms a gate oxide of the trench-MOSFET and that separates polysilicon gate region 21 from body region 25. Polysilicon gate region 21 is electrically connected to a gate terminal (not shown). By controlling a charge or voltage on polysilicon gate region 21, a channel can be formed in body region 25 between source region 24 and drift region 23, thereby enabling a current flow from the drain terminal of the trench-MOSFET to a source terminal of the MOSFET, which is electrically connected to source region 24.

A reduced surface field (RESURF) structure can be used for the purpose of enhancing a breakdown voltage of the trench-MOSFET. Referring to figure 1, the RESURF structure is formed by a second oxide layer 26b arranged on a part of a side wall and bottom of trench 22 combined with a buried polysilicon source region 27 inside trench 22 and separated from the sidewall and bottom of trench 22 by second oxide layer 26b. Buried polysilicon source region 27 is arranged below polysilicon gate region 21 and is separated therefrom by a third oxide layer 26c. A charge or voltage at buried polysilicon source region 27 can be controlled to alter the electric field distribution inside the semiconductor device to thereby increase a critical drain-to-source voltage at which the device breaks down. For example, by biasing buried polysilicon source region 27 at zero Volts, the RESURF effect is obtained, spreading the drain potentials uniformly across the drift region 23 and thereby creating a rectangular electric field distribution. In addition, buried polysilicon source region 27 partially shields polysilicon gate region 21 from drain region 23, thereby reducing a gate-drain capacitance and, consequently, improving a switching performance of the device. When including the RESURF structure, third oxide layer 26c is used to separate polysilicon gate region 21 and buried polysilicon source region 27. Third oxide layer 26c joins with first oxide layer 26a and second oxide layer 26b at an intersection region 28. Third oxide layer 26c, and therefore the interface between polysilicon gate region 21 and buried polysilicon source region 27, is arranged at or close to a same depth as an interface between body region 25 and drift region 23. In particular, a bottom surface of polysilicon gate region 21 is substantially level with a bottom surface of body region 25.

For MOSFETs, including trench-MOSFETs, a gate-drain capacitance and an on-resistance Rds-on of the transistor are important parameters. The on-resistance may be defined as a resistance between the drain and source terminal when the transistor is activated. The on-resistance may also be characterized by a specific resistance Rsp corresponding to a resistance per mm² between the drain and source terminal.

While the known device shown in Figure 1 exhibits a lower gate-drain capacitance with respect to a three-terminal device that does not include the buried source region, its on-resistance is typically significantly greater than that of the three-terminal device. For various applications, such as automotive, both a low gate-drain capacitance and a low on-resistance are needed, and this trade-off between on-resistance and dynamic performance may not be acceptable. Therefore, there is a need for a trench-MOSFET having an improved gate-drain capacitance as well as a relatively low on-resistance.

### SUMMARY

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a trench-gate semiconductor device is provided. The semiconductor device comprises one or more unit cells arranged in a semiconductor region. Each unit cell comprises a trench, a first oxide layer arranged on an upper portion of a side wall of the trench, said first oxide layer forming a gate oxide of the unit cell, and a second oxide layer arranged on a lower portion of the side wall and on a bottom of the trench.

Furthermore, each unit cell comprises a first polysilicon region arranged inside the trench, separated from the upper portion of the side wall by the first oxide layer, said first polysilicon region forming a gate of the unit cell, a second polysilicon region arranged inside the trench, separated from the lower portion of the side wall and from the bottom of the trench by the second oxide layer, said second polysilicon region forming a buried source of the unit cell, and a third oxide layer arranged in between the first polysilicon region and the second polysilicon region.

Furthermore, each unit cell comprises a body region of a first charge type, wherein the body region is separated from the first polysilicon region by the first oxide layer. A first distance from a top surface of the semiconductor region to a bottom surface of the body region is equal to or less than 3 micron. In addition, a second distance from said top surface of the semiconductor region to a bottom surface of the first polysilicon region extends at least 0.3 micron beyond said bottom surface of the body region.

The Applicant has found that, by extending the first polysilicon region beyond the bottom surface of the body region according to the present disclosure, a RESURF structure with a low on-resistance can be achieved. More in particular, through simulation, the Applicant has found that extending the depth of the first polysilicon region to at least 0.3 micron beyond the depth of the body region, for example 0.5 micron, the on-resistance of the device can be improved by more than 20%. Moreover, extending the depth of the first polysilicon region to at least 0.3 micron beyond the depth of the body region, and preferably between 0.3 micron and 0.8 micron, provides a device with an improved and more favourable trade-off between gate-drain capacitance and on-resistance.

In some embodiments, a ratio of the second distance and the first distance may be at least 1.5.

The trench may comprise a first trench and a second trench extending from a bottom of the first trench. The upper portion may correspond to a side wall of the first trench and the bottom portion may correspond to a side wall of the second trench. The first polysilicon region may be arranged inside the first trench and the second polysilicon region may be arranged inside the second trench.

By using a dual trench process to manufacture a dual trench semiconductor device, the bottom surface of the first polysilicon region can be more accurately positioned relative to a bottom surface of the body region. However, the present disclosure is not limited thereto, and a single-trench semiconductor device using a single-trench process is also envisaged.

Each of the first, second and third oxide layers may jointly form a contiguous oxide region. Furthermore, the third oxide layer can be arranged at or near a border between the first trench and the second trench. Similarly, the buried polysilicon source region may extend to a boundary between the first and second trench.

The semiconductor region may be formed by a semiconductor substrate of a second charge type different from the first charge type, and an epitaxial layer of the second charge type arranged on top of the semiconductor substrate. A dopant concentration of the epitaxial layer may be less than a dopant concentration of the semiconductor substrate. In some embodiments, the trench may be arranged only in the epitaxial layer of the semiconductor region. For example, the single trench in a single-trench device, or the first and second trench in a dual-trench device, may be arranged only in the epitaxial layer.

The one or more unit cells may each further comprise a source region of the second charge type, wherein the source region vertically extends from a top surface of the semiconductor body to the body region. Furthermore, in some embodiments, a dopant concentration of the source region may be greater than that of the epitaxial layer, in some further embodiments at least two orders of magnitude greater.

The doping in the epitaxial layer is typically 1e12cm-2. A well-designed RESURF drift region may be able to support a drain potential in the region of 30V/micron. For such devices, the body region may typically be doped at 1e13cm-2 and may be about 1.2 micron deep. The source region may typically be doped at 5e15cm-2 and may be about 0.25 micron deep, as measured from the surface of the semiconductor region. Hence, a typical channel length is in the region of a micron but depends upon the breakdown voltage rating.

Each unit cell may further comprise a moat region. The moat region electrically shorts the source and body regions to enable a good ohmic contact. The moat can be filled with a source metallization. In some embodiments that comprise a plurality of unit cells, the source metallization is applied to all the moat regions so that all unit cells are at the same source potential. The moat region can be arranged, preferably centrally, in between the first and second trench of the corresponding unit cell and a first and second trench of an adjacent unit cell. The moat region is spaced apart from the first and second trench of the corresponding unit cell and is formed by etching through the source region into the body region.

The one or more unit cells may further comprise a fourth oxide layer arranged on top of the first trench and the source region, and a fifth oxide layer arranged on top of the fourth oxide layer. It should be noted that other insulating materials could be used instead of the fourth and/or fifth oxide layers. Furthermore, the fifth oxide layer can be used as a mask for etching the moat region and the fourth oxide layer can be used to improve the ion implantation for the formation of the body region and source region.

The semiconductor device may further comprise a first metal layer, such as aluminium, arranged on one or more of the one or more unit cells of the semiconductor device, wherein the metal layer can be configured to provide a source contact for the one or more unit cells, to electrically contact the body region, and, optionally, to electrically connect the source region to the buried source. Furthermore, the semiconductor device may further comprise a metal contact arranged on top of the first polysilicon region of one or more of said one or more unit cells and configured to provide a gate contact for said one or more unit cells, wherein the metal contact is preferably arranged at or near an end of the one or more unit cells where the metal layer is absent.

Typically, the unit cells are elongated. Following the formation of the moat region, aluminium is deposited or sputtered and is masked and etched to form the source and gate metallization. The source metallization contact to the buried polysilicon source region is typically achieved at the end of the unit cell where the buried source polysilicon region extends to the top of the first trench. The gate metallization can contact the gate polysilicon region (typically) at the opposite side of the unit cell.

The one or more unit cells can be identical to one another. In some embodiments, the one or more unit cells may be elongated having a length between 0.5 and 4.0 mm and a width between 0.6 and 2.0 micron. A typical semiconductor device may then comprise 1000 or more of these unit cells arranged next to each other.

A depth of the first trench relative to a top surface of the semiconductor region may lie in a range between 0.5 and 2.0 microns, preferably between 1.0 and 1.5 microns, and/or a depth of the second trench relative to the bottom of the first trench may lie in a range between 0.2 and 2 microns, preferably between 0.4 and 1.0 microns. Preferably, a width of the first polysilicon region and/or second polysilicon region lies in a range between 0.1 and 2.0 micron, preferably between 0.2 and 1 micron, for example 0.5 micron. Here, it is noted that the unit cells need not be identical, and may for example have trenches with differing widths or depths.

The semiconductor region preferably comprises a silicon-based semiconductor region and/or the first oxide layer, the second oxide layer, and the third oxide layer may comprise thermally grown silicon dioxide. Moreover, the semiconductor device can be a trench-gate metal-oxide-semiconductor field-effect transistor, MOSFET.

According to another aspect of the present disclosure, a method for manufacturing a unit cell of the trench-gate semiconductor device described above is provided. The method comprises forming a structure in a semiconductor region, the structure comprising a trench, a first oxide layer arranged on an upper portion of a side wall of the trench, said first oxide layer forming a gate oxide of the unit cell, and a second oxide layer arranged on a lower portion of the side wall and on the bottom of the trench.

The structure further comprises a first polysilicon region arranged inside the trench and separated from the upper portion of the side wall by the first oxide layer, said first polysilicon region forming a gate of the unit cell, a second polysilicon region arranged inside the trench, separated from the lower portion of the side wall and from the bottom of the trench by the second oxide layer, said second polysilicon region forming a buried source of the unit cell, and a third oxide layer arranged in between the first polysilicon region and the second polysilicon region.

The method further comprises implanting a body region of a first charge type in the semiconductor region, The body region is separated from the first polysilicon region by the first oxide layer.

A first distance from a top surface of the semiconductor region to a bottom surface of the body region is equal to or less than 3 micron. In addition, a second distance from said top surface of the semiconductor region to a bottom surface of the first polysilicon region extends at least 0.3 micron beyond said bottom surface of the body region. In a preferred embodiment, the second distance may extend between 0.3 micron and 0.8 micron beyond the bottom surface of the body region. In other words, the second distance may be at least 0.3 micron greater than the first distance. In some embodiments, a ratio of the second distance and the first distance may be at least 1.5.

Forming the structure may comprise forming a first trench in the semiconductor region, a first side wall thereof corresponding to the upper portion of the side wall of the trench. Forming the structure may further comprise providing the first oxide layer on the first side wall and a bottom of the first trench. Furthermore, forming the structure may comprise depositing a second mask layer inside the first trench and etching, preferably using dry-etching, the second mask layer to expose the underlying semiconductor region at a bottom of the first trench while the second mask keeps covering the first oxide layer on the side wall of the first trench at least to a large extent. Forming the structure may additionally comprise forming a second trench using the etched second mask layer. The second trench may thus be formed extending from the bottom of the first trench. A second side wall and bottom of the second trench may correspond to the lower portion of the side wall and the bottom of the trench, respectively.

Forming the structure may further comprise providing a second oxide layer on the side wall and bottom of the second trench with the etched second mask layer still at least partially in place. Forming the structure may further comprise depositing a first polysilicon layer on the second oxide layer in the second trench and forming the second polysilicon region. Forming the structure may further comprise providing the third oxide layer on top of the second polysilicon layer, removing the second mask layer, and depositing a second polysilicon layer on the third oxide layer and first oxide layer and forming the first polysilicon region.

Providing the first, second and third oxide layers may comprise thermally growing said first, second and third oxide layers. Said first, second and third oxide layers may jointly form a contiguous oxide region.

The method may further comprise, prior to thermally growing the third oxide layer, etching a part of the etched second mask layer at or near a bottom of the first trench. The partial etch of the etched second mask improves the join between the first, second, and third oxide layers. More in particular, the Applicant has found that the thermal growth of the second oxide layer deforms the second mask layer that is arranged next to the first oxide layer. This deformation, e.g. an inwardly oriented curvature, may deteriorate the join between the first, second, and third oxide layers. This deformation can however be removed by performing an etching step, e.g. a dry-etching step, prior to thermally growing the third oxide layer.

Forming the first trench may further comprise depositing and patterning a first mask layer, and forming the first trench using the patterned first mask layer.

Alternatively to the dual trench manufacturing process described above, a single trench process is also envisaged. In such process, forming the structure may comprise forming a trench, preferably using a mask layer, depositing oxide material and a first polysilicon layer in the trench, and etching part of said first oxide material and first polysilicon layer to form the second oxide layer and the second polysilicon region. Forming the structure may further comprise removing the mask layer, if applicable, depositing oxide material in the trench and etching part of said oxide material to form the first oxide layer and the third oxide layer, or thermally growing said first oxide layer and third oxide layer, and depositing a second polysilicon layer in the trench and etching part of said second polysilicon layer to form the first polysilicon region.

The semiconductor region may comprise an epitaxial layer of a second charge type different from the first charge type arranged on top of a semiconductor substrate of the second charge type. A dopant concentration of the epitaxial layer region may be less than a dopant concentration of the semiconductor substrate. In some embodiments, the first trench and the second trench may be formed only in the epitaxial layer of the semiconductor region.

The method may further comprise depositing a fourth oxide layer, and forming a source region in the semiconductor body by implanting dopants of the second charge type through the fourth oxide layer, wherein the source region vertically extends from a top surface of the semiconductor body to the body region.

The method may further comprise depositing and patterning a fifth oxide layer on top of the fourth oxide layer. The method may additionally comprise forming, using the fifth oxide layer as a mask, a moat region in the semiconductor body. More in particular, those parts of the semiconductor region that are not covered by the fifth oxide layer may be etched into the body region.

The method may further comprise providing a metal layer on top of one or more of said one or more unit cells, wherein the metal layer is configured to provide a source contact for the unit cell, to electrically contact the body region, and to optionally electrically connect the source region to the buried source. Additionally, the method may further comprise forming a metal contact on top of the first polysilicon region for providing a gate contact for the unit cell, wherein the metal contact is preferably formed at or near an end of the unit cell where the metal layer is absent.

A plurality of unit cells can be formed simultaneously by performing the method, wherein the unit cells are preferably identical to each other.

A depth of the first trench relative to a top surface of the semiconductor region may lie in a range between 0.5 and 2.0 microns, preferably between 1.0 and 1.5 microns, and/or a depth of the second trench relative to the bottom of the first trench may lie in a range between 0.2 and 2 microns, preferably between 0.4 and 1.0 microns. A width of the first polysilicon region and/or the second polysilicon region, may lie in a range between 0.1 and 2 microns, preferably between 0.2 and 1.0 micron, and may depend on the application, such as the required breakdown voltage rating Here, it is noted that the unit cells need not be identical, and may for example have trenches and/or polysilicon regions with differing widths or depths.

The semiconductor region is preferably a silicon-based semiconductor region. At least one of the first mask layer and the second mask layer may comprise silicon nitride or oxide nitride oxide, 'ONO'.

The trench-gate semiconductor device may be a trench-gate metal-oxide-semiconductor field-effect transistor, MOSFET.

### DESCRPITION OF THE DRAWINGS

Next, the present disclosure will be described with reference to the appended drawings, wherein:
Figure 1 is a cross-sectional view of a trench-MOSFET known from the prior art;
Figures 2A-2H are cross-sectional views of a unit cell of a trench-gate semiconductor device at various processing steps according to some embodiments of the present disclosure;
Figure 3 is a simplified cross-sectional view of a unit cell of a trench-gate semiconductor device according to an embodiment of the present disclosure; and
Figure 4 is a simplified top view of a trench-gate semiconductor device having a plurality of unit cells according to an embodiment of the present disclosure.

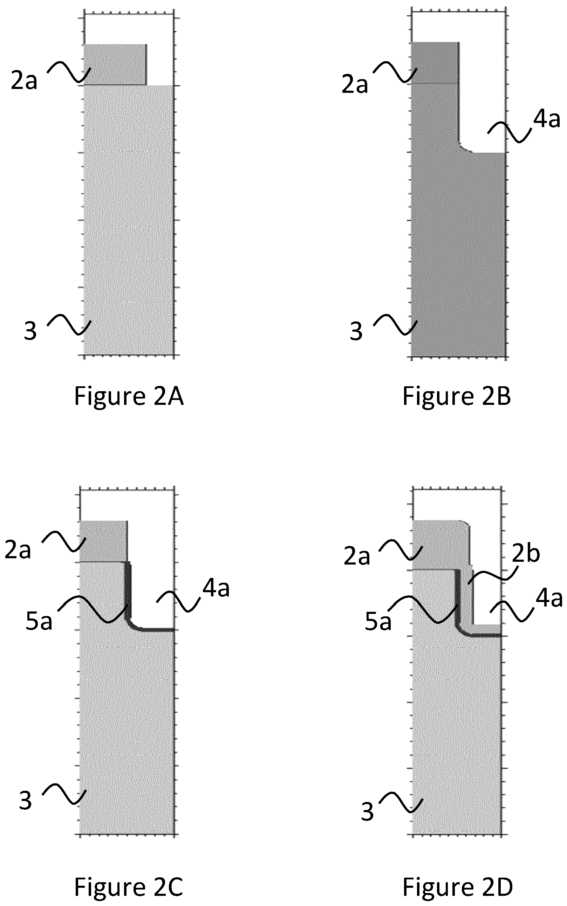

Hereinafter, reference will be made to the appended drawings. It should be noted that identical reference signs may be used to refer to identical or similar components. Furthermore, the unit cells depicted in Figure 1 and Figures 2A-2H are symmetric along the vertical axis in these figures. For illustrative purposes, only half of the unit cell is therefore illustrated.

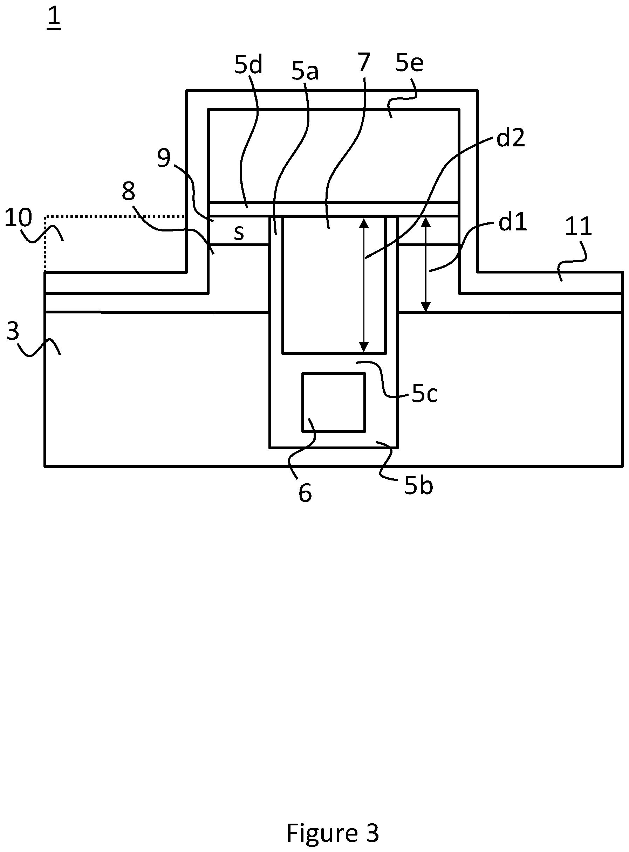

Figures 2A-2H illustrate the process of the first part of manufacturing a unit cell 1 of a trench-gate semiconductor device 100 in which a silicon semiconductor region is used. More in particular, Figures 2A-2H relate to a dual trench process for manufacturing a dual-trench semiconductor device. Remaining process steps of the dual trench process will be described with reference to Figure 3. It is noted that this process can be used to manufacture individual unit cells separately, or to manufacture multiple unit cells simultaneously on a same semiconductor region.

Referring to Figure 2A, a first mask layer 2a is deposited and patterned onto a surface of a semiconductor region. For example, first mask layer 2a is provided on top of an epitaxial layer 3 arranged on top of a semiconductor substrate (not shown). First mask layer 2a is patterned such that a portion of the semiconductor region where trench 4a is to be provided is exposed, while a remaining portion of the semiconductor body is covered. For example, silicon nitride or oxide nitride oxide (ONO) can be used for first mask layer 2a.

Referring to Figure 2B, first trench 4a is then formed by etching back the exposed part of the semiconductor region (e.g. epitaxial layer 3). For example, first trench 4a may have a depth in the range between 1.0 microns and 1.5 microns. The depth of first trench 4a may depend on the desired breakdown voltage rating or the required channel length of semiconductor device 100.

Referring to Figure 2C, after having formed first trench 4a, a first oxide layer 5a is provided on a side wall and bottom of first trench 4a. A portion of first oxide layer 5a on the side wall of first trench 4a will eventually form the gate oxide of semiconductor device 100. For example, first oxide layer 5a is thermally grown onto the side wall and bottom of first trench 4a. An optimal thickness of first oxide layer 5a may depend on the application for which semiconductor device 100 will be used. The present disclosure is particularly applicable for trench-MOSFETs operable in a frequency range between DC and 500 kHz and handling a current between 5A per mm². For such devices, first oxide layer 5a generally has a thickness matching a given voltage rating. First oxide layer 5a forms a gate oxide of the unit cell and may have a typical thickness in a range between 10 - 200 nm, through the present disclosure is not limited thereto.

Referring to Figure 2D, after having provided first oxide layer 5a, a second mask layer 2b is deposited, in particular onto first oxide layer 5a on the bottom and side wall of first trench 5a.

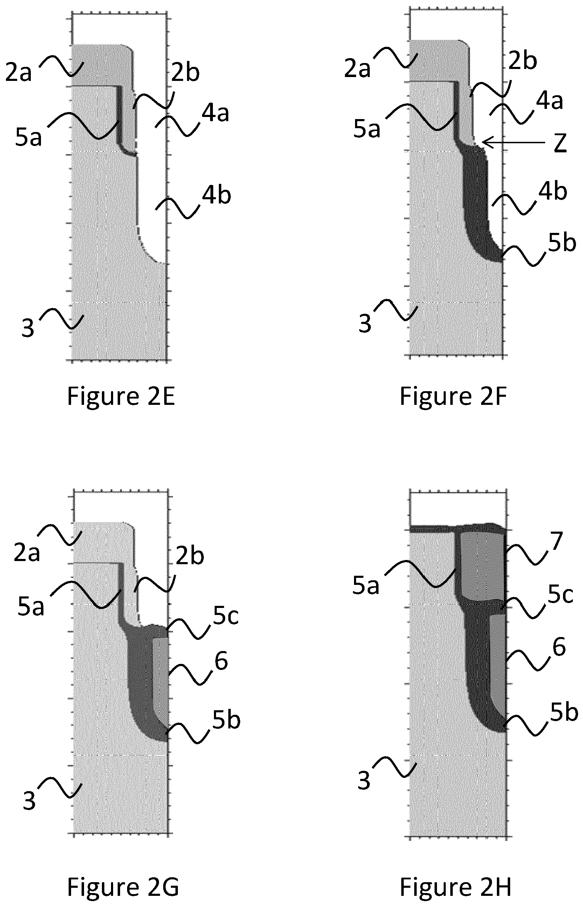

Referring to Figure 2E, second mask layer 2b is dry-etched, thereby exposing first oxide layer 5a at the bottom of first trench 4a while covering first oxide layer 5a on the side wall of first trench 4a. Then, the exposed first oxide layer 5a is dry-etched to expose the semiconductor region underneath. Thereafter, a second trench 4b is etched into the semiconductor region (e.g. epitaxial layer 3) extending from the bottom of first trench 4a and using etched second mask layer 2b as a protective mask, that is, second mask layer 2b defines a trench mask for second trench 4b. Second trench 4b may serve as a basis for a RESURF structure. Second trench 4b may have a depth between 0.4 and 1.0 microns, such as 0.6 microns.

Referring to Figure 2F, a second oxide layer 5b is provided on a second side wall and bottom of second trench 4B. In particular, second oxide layer 5b is provided with the patterned second mask layer 2b still at least partially in place. For example, second oxide layer 5b is thermally grown onto a second side wall and bottom of second trench 4b. Second oxide layer 5b may be thicker than first oxide layer 5a. For example, second oxide layer 5b may have a thickness in a range between 0.1 - 0.5 micron, such as 0.2 micron.

Referring to Figure 2G, polysilicon material is deposited onto second oxide layer 5b. After having deposited the polysilicon material, the polysilicon material is etched back, for example until a bottom of second mask layer 2b on the first side wall of first trench is exposed. In other words, the polysilicon material is etched back to a border between first and second trenches 4a and 4b, and the remaining polysilicon material forms second polysilicon region 6, which forms a buried source of unit cell 1. Then, a third oxide layer 5c is provided on top of second polysilicon region 6 which joins with first and second oxide layers 5a and 5b to form a contiguous oxide region. Optionally, a portion of second mask layer 2b is additionally etched prior to providing third oxide layer 5C, to ensure a smooth join between the oxide layers 5a-5c. As an example, third oxide layer 5c is thermally grown onto second polysilicon region 4b. Third oxide layer 5c may also be thicker than first oxide layer 5a, and may for example lie in a range between 0.1 - 0.5 micron. Second oxide layer 5b and third oxide layer 5c may have a roughly corresponding thickness, though the present disclosure is not limited thereto.

The Applicant has found that by thermally growing second oxide layer 5b, already arranged second mask layer 2b may deform. This is illustrated using arrow Z in Figure 2F. More in particular, second mask layer 2b may extend inward. This inwardly oriented portion of second mask layer 2b can be removed using a dry-etching technique prior to thermally growing third oxide layer 5c. In this manner, the join between oxide layers 5a-5c may be improved.

Referring to Figure 2H, polysilicon material is deposited onto third oxide layer 5c and first oxide layer 5a and is etched back to a top surface of the semiconductor region. The remaining polysilicon material forms a first polysilicon region 7, which forms a gate of unit cell 1.

Figure 3 shows a simplified cross-sectional view of a completed unit cell 1. After first trench 4a and second trench 4b are filled with polysilicon and oxide layers, a fourth oxide layer can optionally be provided on top of the semiconductor region. Although not required, fourth oxide layer 5d may be beneficial during dopant implantation into the semiconductor region, as fourth oxide layer 5d prevents or limits channelling of the dopants and increases implantation uniformity in the implanted regions.

A body region 8 is implanted with dopants of the first charge type different from the second charge type, optionally through fourth oxide layer 5d, using for example a blanket implantation technique. Then, a source region 9 is implanted with dopants of the second charge type, optionally through fourth oxide layer 5d. In particular, body region 8 may be formed laterally adjacent to first polysilicon region 7 and may be separated from first polysilicon region 7 by first oxide layer 5a. Source region 9 may extend from a top surface of the semiconductor region to body region 8.

In unit cell 1 according to the present disclosure, body region 8 has a depth defined as afirst distance d1 from a top surface of the semiconductor region (e.g., a top surface of epitaxial layer 3) to a bottom surface of body region 8, and first polysilicon region 7 has a depth defined as a second distance d2 from said top surface of the semiconductor region to a bottom surface of said first polysilicon region 7, wherein second distance d2 is at least 0.3 micron greater than first distance d1. In other words, the bottom surface of first polysilicon region 7 extends at least 0.3 micron beyond the bottom surface of body region 8 in a depth direction. The depth direction may be a direction that is perpendicular to the top surface of the semiconductor region (e.g., a top surface of epitaxial layer 3). In some embodiments, a ratio of second distance d2 and first distance d1 is equal to or greater than 1.5.

For example, when implanting body region 8 with dopants, a depth of first polysilicon region 7 is taken into account to ensure that the appropriate relative depth of body region 8 and first polysilicon region 7 is obtained. Additionally or alternatively, when forming first trench 4A and when forming first polysilicon region 7, a desired depth of body region 8 is taken into account to arrive at unit cell 1 having the appropriate relative depth described above. A depth of body region 8 may for example depend on the desired channel length of the device.

For example, source region 9 is implanted into the body of the device and is typically 0.2 microns deep in body region 8 that is 1 micron deep. In that case, the depth of first polysilicon region 7 may for example be 1.5 microns. In another example, body region 8 may have a depth of 0.6 microns, and a depth of first polysilicon region 7 may be 0.9 microns or greater.

A fifth oxide layer 5e may then be deposited on fourth oxide layer 5d and may be subsequently patterned. Then, a moat region 10 can be etched into the semiconductor region into body region 8, wherein fifth oxide layer 5e serves as a protective mask to prevent etching of the trench structure, source region 9 and body region 8. Moat region 10 is configured to provide an electrical contact to source region 9 and body region 8.

Then, a metal layer 11 is provided on top of unit cell 1 and other unit cells in semiconductor device 100. Metal layer 11 provides a single contact to one or more source regions 9 of one or more unit cells 1 in semiconductor device 100. Fifth oxide layer 5e isolates the trench structure from metal layer 11. Prior to providing metal layer 11, an ion implant may be used to improve the Ohmic contact between metal layer 11 and body region 8. Metal layer 11 may for example have a thickness in a range between 3 - 5 microns, though the present disclosure is not limited thereto.

Instead of the dual-trench process described above with reference to Figures 2A-2H and 3 a single-trench manufacturing process could similarly be applied. That is, the above structure including first, second and third oxide layers 5a-5c, first polysilicon region 7 and second polysilicon region 6 may be formed in a single trench rather than in a first and second trench as defined above, while nevertheless maintaining the desired relative depths of body region 8 and first polysilicon region 7.

Referring to Figure 3, the single trench manufacturing process may first comprise depositing and patterning a mask layer, e.g. silicon nitride, on top of epitaxial layer 3. Using the mask layer, epitaxial layer 3 is etched to form a single trench. Typically, the trench may extend through a substantial part of epitaxial layer. After etching, an oxide layer is deposited on the structure including the trench and the mask layer, followed by a deposition of polysilicon material in trench and on the mask layer. The deposited oxide material and polysilicon material are etched to a first depth inside trench such that the remaining deposited oxide material defines second oxide layer 5b and the remaining deposited polysilicon material defines second polysilicon region 6. Following this, the mask layer is removed, and a silicon dioxide layer is deposited or thermally grown on epitaxial layer 3 and in the trench to form first oxide layer 5a and third oxide layer 5c. Then, a polysilicon material is deposited and etched back to an upper surface of the trench such that the remaining polysilicon material in the trench above third oxide layer 5c defines first polysilicon region 7. Next, a blanket ion implantation may be performed to form body region 8 and a subsequent ion implantation may be performed to form source region 9. This latter ion implantation may be masked to ensure ion implantation is only carried out in an active area of the semiconductor region. These implantation steps also define a drift region as being the non-implanted region of epitaxial layer 3 and define a length of said drift region from a bottom of body region 8 to the substrate (not shown).

Similarly, in the single-trench manufacturing process according to the present disclosure, second distance d2 is equal to at least 1.5 times first distance d1. For example, during implanting body region 8, the depth of first polysilicon region 7 is taken into account to ensure a relative depth of first polysilicon region 7 with respect to the depth of body region 8. Additionally or alternatively, the formed trench is made sufficiently deep to ensure, after forming second oxide layer 5b, second polysilicon region 6 and third oxide layer 5c, that first polysilicon region 7 extends sufficiently deep into the semiconductor region with respect to body region 8.

First polysilicon region 7 and/or second polysilicon region 6 may have a width, taken perpendicularly to the depths indicated in Figure 3 in a same plane as the cross-sectional view, in a range between 0.1 and 2 microns, preferably between 0.2 and 1.0 micron. However, the present disclosure is not limited thereto.

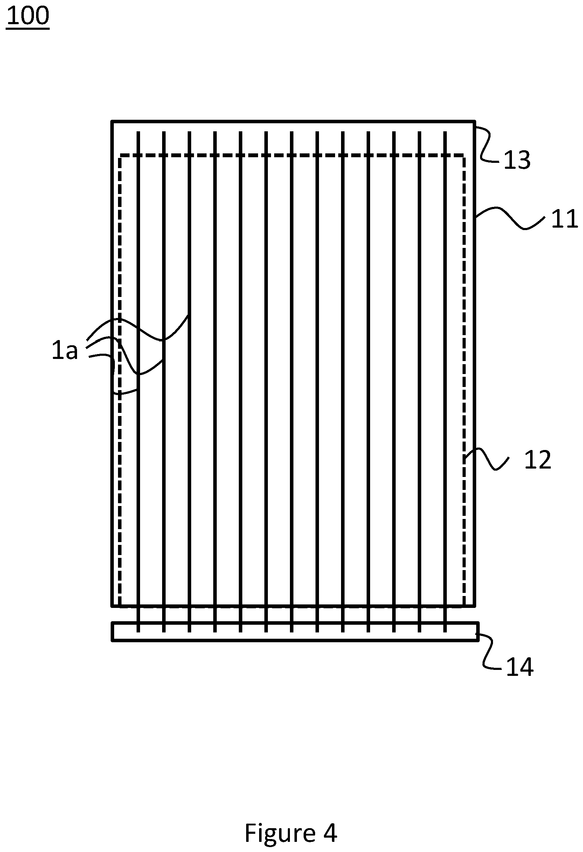

Figure 4 shows a simplified top view of semiconductor device 100 comprising a plurality of unit cells. Of these unit cells, a metal layer 11 is illustrated that extends over an active region 12.

The trench forms a trench stripe that extends over and beyond active area 12. In the dual-trench device described above, first trenches 4a and second trenches 4b jointly form a trench stripe that extends over and beyond active area 12. Metal layer 11 also contacts the buried polysilicon source region at the end 13 of the trench stripe outside active area 12 where the polysilicon was masked to stop it from being etched during formation of the second polysilicon region 6 as was illustrated in Figure 2G. The contact to source region 9 is defined at the same stage as patterning oxide 5e in the unit cell. The patterned gate metallization 14 contacts first polysilicon region 7 of multiple unit cells at the opposite ends of the trench stripes. This contact to first polysilicon regions 7 is also defined at the same stage as patterning oxide 5e in the unit cell.

In the above embodiments, the first charge type may refer to an n-type doping, and the second charge type may refer to a p-type doping, or vice versa.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims.

## Claims

1. A trench-gate semiconductor device, the semiconductor device comprising one or more unit cells arranged in a semiconductor region, wherein each unit cell comprises:
a trench;
a first oxide layer arranged on an upper portion of a side wall of the trench, said first oxide layer forming a gate oxide of the unit cell;
a second oxide layer arranged on a lower portion of the side wall and on a bottom of the trench;
a first polysilicon region arranged inside the trench, separated from the upper portion of the side wall by the first oxide layer, said first polysilicon region forming a gate of the unit cell;
a second polysilicon region arranged inside the trench, separated from the lower portion of the side wall and from the bottom of the trench by the second oxide layer, said second polysilicon region forming a buried source of the unit cell;
a third oxide layer arranged in between the first polysilicon region and the second polysilicon region; and
a body region of a first charge type, wherein the body region is separated from the first polysilicon region by the first oxide layer,
wherein a first distance d1 from a top surface of the semiconductor region to a bottom surface of the body region is equal to or less than 3 micron, and wherein a second distance d2 from said top surface of the semiconductor region to a bottom surface of the first polysilicon region extends at least 0.3 micron beyond said bottom surface of the body region .

2. The semiconductor device according to claim 1, wherein the trench comprises a first trench, and a second trench extending from a bottom of the first trench,
wherein the upper portion corresponds to a side wall of the first trench and wherein the lower portion corresponds to a side wall of the second trench,
wherein the first polysilicon region is arranged inside the first trench and wherein the second polysilicon region is arranged inside the second trench .

3. The semiconductor device according to claim 1 or 2, wherein each of the first, second and third oxide layer jointly form a contiguous oxide region.

4. The semiconductor device according to any of the previous claims, wherein the semiconductor region is formed by a semiconductor substrate of a second charge type different from the first charge type, and an epitaxial layer of the second charge type arranged on top of the semiconductor substrate, wherein a dopant concentration of the epitaxial layer is less than a dopant concentration of the semiconductor substrate, wherein the first trench and the second trench are preferably arranged only in the epitaxial layer of the semiconductor region.

5. The semiconductor device according to any of the previous claims, wherein the one or more unit cells further comprise a source region of the second charge type, wherein the source region vertically extends from a top surface of the semiconductor region to the body region,
wherein the dopant concentration of the source region is preferably greater than that of the epitaxial layer, more preferably at least two orders of magnitude greater,
wherein, preferably:
each unit cell further comprises a moat region arranged, preferably centrally, in between the first and second trench of the corresponding unit cell and a first and second trench of an adjacent unit cell;
the moat region is spaced apart from the first and second trench of the corresponding unit cell; and
the moat region is formed by an etch through the source region into the body region.

6. The semiconductor device according to any of the previous claims, wherein the one or more unit cells further comprise a fourth oxide layer arranged on top of the first trench and the source region, and a fifth oxide layer arranged on top of the fourth oxide layer .

7. The semiconductor device according to any of the previous claims, wherein the semiconductor device further comprises a metal layer arranged on top of one or more of said one or more unit cells of the semiconductor device, wherein the metal layer is configured to provide a source contact for the one or more unit cells, to electrically contact the body region, and, in so far as depending on claim 5, to optionally electrically connect the source region to the buried source,
wherein the semiconductor device preferably further comprises a metal contact arranged on top of the first polysilicon region of one or more of said one or more unit cells and configured to provide a gate contact for said one or more unit cells, wherein the metal contact is preferably arranged at or near an end of said one or more unit cells where the metal layer is absent.

8. The semiconductor device according to any of the previous claims, wherein the one or more unit cells are identical to one another; and/or
wherein the second distance d2 extends between 0.3 micron and 0.8 micron beyond the bottom surface of the body region; and/or
wherein a depth of the first trench relative to a top surface of the semiconductor region lies in a range between 0.5 and 2.0 microns, preferably between 1.0 and 1.5 microns; and/or
wherein a depth of the second trench relative to the bottom of the first trench lies in a range between 0.2 and 2.0 microns, preferably between 0.4 and 1.0 microns; and/or
wherein a width of the first polysilicon region and/or a width of the second polysilicon region lies in a range between 0.1 and 2.0 microns; and/or
wherein the semiconductor region comprises a silicon-based semiconductor body; and/or
wherein the first oxide layer, the second oxide layer and the third oxide layer comprise silicon dioxide; and/or
wherein the semiconductor device is a trench-gate metal-oxide-semiconductor field-effect transistor, MOSFET.

9. A method for manufacturing a unit cell of the trench-gate semiconductor device as defined by any of the previous claims, comprising:
forming a structure in a semiconductor region, the structure comprising:
a trench;
a first oxide layer arranged on an upper portion of a side wall of the trench, said first oxide layer forming a gate oxide of the unit cell;
a second oxide layer arranged on a lower portion of the side wall and on the bottom of the trench;
a first polysilicon region arranged inside the trench and separated from the upper portion of the side wall by the first oxide layer, said first polysilicon region forming a gate of the unit cell;
a second polysilicon region arranged inside the trench, separated from the lower portion of the side wall and from the bottom of the trench by the second oxide layer, said second polysilicon region forming a buried source of the unit cell; and
a third oxide layer arranged in between the first polysilicon region and the second polysilicon region; and
implanting a body region of a first charge type in the semiconductor region, wherein the body region is separated from the first polysilicon region by the first oxide layer,
wherein a first distance d1 from a top surface of the semiconductor region to a bottom surface of the body region is equal to or less than 3 micron, and wherein a second distance d2 from said top surface of the semiconductor region to a bottom surface of the first polysilicon region extends at least 0.3 micron beyond said bottom surface of the body region .

10. The method according to claim 9, wherein forming the structure comprises:
forming a first trench in the semiconductor region, a first side wall thereof corresponding to the upper portion of the side wall of the trench;
providing the first oxide layer on the first side wall and on a bottom of the first trench;
depositing a second mask layer inside the first trench and etching, preferably using dry-etching, the second mask layer to expose the underlying semiconductor region at a bottom of the first trench while the second mask keeps covering the first oxide layer on the first side wall of the first trench at least to a large extent;
forming a second trench using the etched second mask layer, said second trench extending from the bottom of the first trench, wherein a second side wall and bottom of the second trench corresponds to the lower portion of the side wall and the bottom of the trench, respectively;
providing the second oxide layer on the second side wall and bottom of the second trench with the etched second mask layer still at least partially in place;
depositing a first polysilicon layer on the second oxide layer in the second trench and forming the second polysilicon region;
providing the third oxide layer on top of the second polysilicon layer;
removing the second mask layer; and
depositing a second polysilicon layer on the third oxide layer and first oxide layer and forming the first polysilicon region .

11. The method according to claim 10, wherein providing the first, second and third oxide layers comprises thermally growing said first, second and third oxide layers, wherein said first, second and third oxide layers jointly form a contiguous oxide region, wherein the method preferably further comprises, prior to thermally growing the third oxide layer, etching a part of the etched second mask layer at or near a bottom of the first trench; and/or
wherein forming the first trench further comprises depositing and patterning a first mask layer, and forming the first trench using the patterned first mask layer .

12. The method according to claim 9, wherein forming the structure comprises:
forming a trench, preferably using a mask layer;
depositing oxide material and a first polysilicon layer in the trench, and etching part of said first oxide material and first polysilicon layer to form the second oxide layer and the second polysilicon region;
removing the mask layer, if applicable; and
depositing oxide material in the trench and etching part of said oxide material to form the first oxide layer and the third oxide layer, or thermally growing said first oxide layer and third oxide layer; and
depositing a second polysilicon layer in the trench and etching part of said second polysilicon layer to form the first polysilicon region .

13. The method according to any of the claims 9-12, wherein the semiconductor region comprises an epitaxial layer of a second charge type different from the first charge type arranged on top of a semiconductor substrate of the second charge type, wherein a dopant concentration of the epitaxial layer is less than a dopant concentration of the semiconductor substrate, the trench, or if applicable the first and second trench, preferably being formed only in the epitaxial layer of the semiconductor region; and/or
wherein the method further comprises depositing a fourth oxide layer and forming a source region in the semiconductor region by implanting dopants of the second charge type through the fourth oxide layer, wherein the source region vertically extends from a top surface of the semiconductor region to the body region, wherein the method preferably further comprises depositing and patterning a fifth oxide layer on top of the fourth oxide layer, and wherein the method more preferably further comprises forming, using the fifth oxide layer as a mask, a moat region in the semiconductor region.

14. The method according to any of the claims 9-13, wherein the method further comprises:
providing a metal layer on top of one or more of said one or more unit cells, wherein the metal layer is configured to provide a source contact for said one or more the unit cells, to electrically contact the body region, and to optionally electrically connect the source region to the buried source,
wherein the method preferably further comprises forming a metal contact on top of the first polysilicon region for providing a gate contact for the unit cell, wherein the metal contact is preferably formed at or near an end of the unit cell where the metal layer is absent.

15. The method according to any of the claims 9-14, wherein a plurality of unit cells are formed simultaneously by performing the method, wherein the unit cells are preferably identical to each other; and/or
wherein the second distance d2 extends between 0.3 micron and 0.8 micron beyond the bottom surface of the body region; and/or
wherein a depth of the first trench relative to a top surface of the semiconductor region lies in a range between 0.5 and 2.0 microns, preferably between 1.0 and 1.5 microns; and/or
wherein a depth of the second trench relative to the bottom of the first trench lies in a range between 0.2 and 2.0 microns, preferably between 0.4 and 1.0 microns, more preferably between 0.4 and 1.2 microns; and/or
wherein a width of the first polysilicon region and/or a width of the second polysilicon region lies in a range between 0.1 and 2.0 microns; and/or
wherein at least one of the first mask layer and the second mask layer comprise silicon nitride or oxide nitride oxide, 'ONO'; and/or
wherein the trench-gate semiconductor device is a trench-gate metal-oxide-semiconductor field-effect transistor, MOSFET.
